# EUROPÄISCHE PATENTSCHRIFT

(11) **EP 0 513 791 B1**
(45) Veröffentlichungstag und Bekanntmachung des Hinweises auf die Patenterteilung: **29.11.1995**
(21) Anmeldenummer: 92108161.8
(22) Anmeldetag: 14.05.1992
(51) Int. Cl.: H03L 7/099, H03L 7/087

(54) **Phasenregelkreis**
Phase locked loop
Boucle à verrouillage de phase

(30) Priorität: 14.05.1991 AT 987/91
(43) Veröffentlichungstag der Anmeldung: 19.11.1992
(73) Patentinhaber: SIEMENS AKTIENGESELLSCHAFT, 80333 München (DE)
(72) Erfinder: Dietrich, Werner, Dipl. Ing., A-1200 Wien (AT)

(56) Entgegenhaltungen:
- US-A- 3 571 743
- US-A- 4 820 993
- US-A- 4 888 564

## Beschreibung

Die Erfindung betrifft digitale Phasenregelkreise wie sie beispielsweise in "Theorie und Anwendungen des Phase-Locked Loops", Roland Best, Der Elektroniker Nr. 6/1975 beschrieben sind.

In digitalen Informationsübertragungssystemen kommt es durch Störungen auf den Leitungen zu Verzerrungen des Taktsignales. Diese können beispielsweise darin bestehen, daß die Flanken der einzelnen Taktimpulse abgeflacht sind oder daß einzelne Impulse völlig unterdrückt sind. In manchen Systemen wird zur Erhöhung der Übertragungskapazität auch auf die Übertragung eines Taktsignals verzichtet. Dieses muß dann aus dem Datensignal abgeleitet werden. Zur Ableitung eines Taktsignals oder zur Wiederherstellung eines gestörten Taktsignales werden digitale Phasenregelkreise verwendet. Weitere beispielhafte Anwendungsfälle für Phasenregelkreise ergeben sich bei der Realisierung von AM-, FM-, PM-Modulatoren/Demodulatoren, Tracking-Filter, Motordrehzahlregelungen usw.

Aus der DE-A- 29 29 127 ist ein Phasenregelkreis bekannt, der einen Voltage-Controlled-Oszillator (VCO) aufweist, d.h. einen in der Frequenz steuerbaren Oszillator. Die Steuerung der Frequenz des Oszillators erfolgt durch die Ausgangsspannung eines Phasendetektors der als Soll-Istwert-Vergleicher dient.

Auch der Gegenstand der GB-A- 2 033 178 umfaßt einen Voltage-Controlled-Oszillator (VCO) der durch das Ausgangssignal eines Phasendetektors angesteuert wird. Diese Oszillatoren erfordern hohen Schaltungsaufwand und sind störanfällig.

Der Erfindung liegt die Aufgabe zugrunde einen mit einfachen Mitteln der digitalen Schaltungstechnik aufgebauten störsicheren Phasenregelkreis anzugeben, der in einem weiten Frequenzbereich einsetzbar ist.

Dies geschieht erfindungsgemäß mit einem digitalen Phasenregelkreis bestehend aus: einer Oszillatorschaltung; einem zwischen zwei Teilungsfaktoren umschaltbaren Frequenzteiler, der einen Steuereingang, einen Signaleingang und einen Signalausgang aufweist und dessen Signaleingang mit einem Ausgang der Oszillatorschaltung verbunden ist; einem an einem Ausgang ein Teilersignal abgebenden Rückführungsteiler, der mit einem Eingang an den Signalausgang des Frequenzteilers angeschlossen ist; einer die Phasenbeziehung zwischen einem durch ein Regelkreis-Eingangssignal und dem Teilersignal gebildeten ersten Signalpaar durch das Tastverhältnis eines ersten Signals an einem ersten Ausgang darstellenden und die Phasenbeziehung n-1 weiterer Signalpaare, die gegenüber dem ersten Signalpaar um einen konstanten Betrag phasenverschoben sind, durch das Tastverhältnis von n-1 weiteren Signalen an n-1 weiteren Ausgängen darstellenden Phasendetektoreinrichtung, deren erster Eingang an den Ausgang des Rückführungsteilers angeschlossen ist und deren zweiter Eingang mit dem Regelkreis-Eingangssignal beaufschlagt ist; einer ein Ausgangssignal mit einer mittleren Frequenz, die dem Tastverhältnis der n Signale an den n Ausgängen der Phasendetektoreinrichtung proportional ist, abgebenden Logikschaltung mit n+1 Eingängen und einem Ausgang, deren erster bis n-ter Eingang mit dem ersten bis n-ten Ausgang der Phasendetektoreinrichtung verbunden sind, deren n+1 -ter Eingang mit dem Signalausgang des Frequenzteilers und deren Ausgang mit dem Steuerausgang des Frequenzteilers verbunden ist.

Der erfindungsgemäße Phasenregelkreis zeichnet sich durch die einfache Realisierbarkeit aus. Weiters ist er für den Einsatz in einem großen Frequenzbereich geeignet. Durch eine entsprechende Ausgestaltung kann der Phasenregelbereich an unterschiedliche Einsatzfälle angepaßt werden.

Zweckmäßig ist es, wenn n gleich zwei ist. Diese Ausgestaltung bringt den Vorteil eines besonders geringen Realisierungsaufwandes.

Eine vorteilhafte Ausgestaltung der Erfindung erhält man dadurch, daß die Phasendetektoreinrichtung folgende Einheiten umfaßt:
einen ersten Phasendetektor mit zwei Eingängen und einem Aus- gang, dessen Eingänge mit den beiden Eingängen der Phasendetektoreinrichtung verbunden sind und dessen Ausgang mit dem ersten Ausgang der Phasendetektoreinrichtung verbunden ist; einen ersten Phasenschieber mit einem Eingang und einem Ausgang, dessen Eingang mit dem ersten Eingang der Phasendetektoreinrichtung verbunden ist; einen zweiten Phasenschieber mit einem Eingang und einem Ausgang, dessen Eingang mit dem zweiten Eingang der Phasendetektoreinrichtung verbunden ist; einen zweiten Phasendetektor mit zwei Eingängen und einem Ausgang, dessen erster Eingang mit dem Ausgang des ersten Phasenschie- bers verbunden ist, dessen zweiter Eingang mit dem Ausgang des zweiten Phasenschiebers verbunden ist und dessen Ausgang mit dem zweiten Ausgang der Phasendetektoreinrichtung verbunden ist.

Die erfindungsgemäße Phasendetektoreinrichtung verhindert bei Anwendungsfällen mit einem großen Verhältnis der Frequenzen von Regelkreis-Eingangssignal und dem Signal am Signalausgang des Frequenzteilers, d.h. bei einem großen Teilungsverhältnis des Rückführungsteilers, das Auftreten von niederfrequenten Störanteilen im Signal am Signalausgang des Frequenzteilers.

Eine vorteilhafte Ausgestaltung der Erfindung besteht auch darin, daß die Logikschaltung folgende Einheiten umfaßt: einen Teiler mit einem Eingang, der mit dem dritten Eingang der Logikschaltung verbunden ist, und mit einem Ausgang; ein erstes UND-Gatter mit zwei Eingängen und einem Ausgang, dessen erster Eingang mit dem ersten Eingang der Logikschaltung und dessen zweiter Eingang mit dem Ausgang des Teilers verbunden ist; einen dritten Phasenschieber mit einem Eingang und einem Ausgang, dessen Eingang mit dem Ausgang des Teilers verbunden ist; ein zweites UND-Gatter mit zwei Eingängen und einem Ausgang, dessen erster Eingang mit dem zweiten Eingang der Logikschaltung und dessen zweiter Eingang mit dem Ausgang des dritten Phasenschiebers verbunden ist; ein EXCLUSIV-ODER-Gatter mit zwei Eingängen, die jeweils mit einem Ausgang der beiden UND-Gatter verbunden sind, und einem Ausgang; und einen Stellteiler mit einem Eingang und einem Ausgang, dessen Eingang mit dem Ausgang des EXCLUSIV-ODER-Gatters und dessen Ausgang mit dem Ausgang der Logikschaltung verbunden ist.

Eine weitere vorteilhafte Ausgestaltung der Erfindung besteht darin, daß die Logikschaltung folgende Einheiten umfaßt: ein erstes JK-Flip Flop, dessen J-Eingang und K-Eingang gemeinsam mit dem ersten Eingang der Logikschaltung verbunden sind und dessen Takteingang mit dem dritten Eingang der Logikschaltung verbunden ist; ein zweites JK-Flip Flop, dessen J-Eingang und K-Eingang gemeinsam mit dem zweiten Eingang der Logikschaltung verbunden sind und dessen Takteingang über einen Inverter mit dem dritten Eingang der Logikschaltung verbunden ist; ein EXCLUSIV-ODER-Gatter mit zwei Eingängen und einem Ausgang, dessen Eingänge jeweils mit einem Datenausgang der beiden JK-Flip Flops verbunden sind; und einen Stellteiler mit einem Eingang und einem Ausgang, dessen Eingang mit dem Ausgang des EXCLUSIV-ODER-Gatters und dessen Ausgang mit dem Ausgang der Logikschaltung verbunden ist.

Die angeführten Ausgestaltungen der Logikschaltung begünstigen den Einsatz des erfindungsgemäßen Phasenregelkreises gerade in der Höchstfrequenztechnik, da sie mittels herkömmlicher logischer Elemente unterschiedlicher Technologie realisiert werden können.

Schließlich besteht eine günstige Ausgestaltung der Erfindung darin, daß als Phasendetektoreinrichtung und als Logikschaltung wenigstens eine Mikroprozessorschaltung benutzt ist.

Der Einsatz von Mikroprozessoren ist besonders günstig bei Phasenregelkreisen mit n größer als zwei.

Die Erfindung wird anhand von Ausführungsbeispielen näher erläutert.

Es zeigen:
- Fig. 1: ein Beispiel des erfindungsgemäßen Phasenregelkreises;
- Fig. 2 und Fig. 4: jeweils ein Ausführungsbeispiel einer Logikschaltung in einem Phasenregelkreis nach Fig. 1 und
- Fig. 3: ein Ausführungsbeispiel für eine Phasendetektoreinrichtung in einem Phasenregelkreis nach Fig. 1.

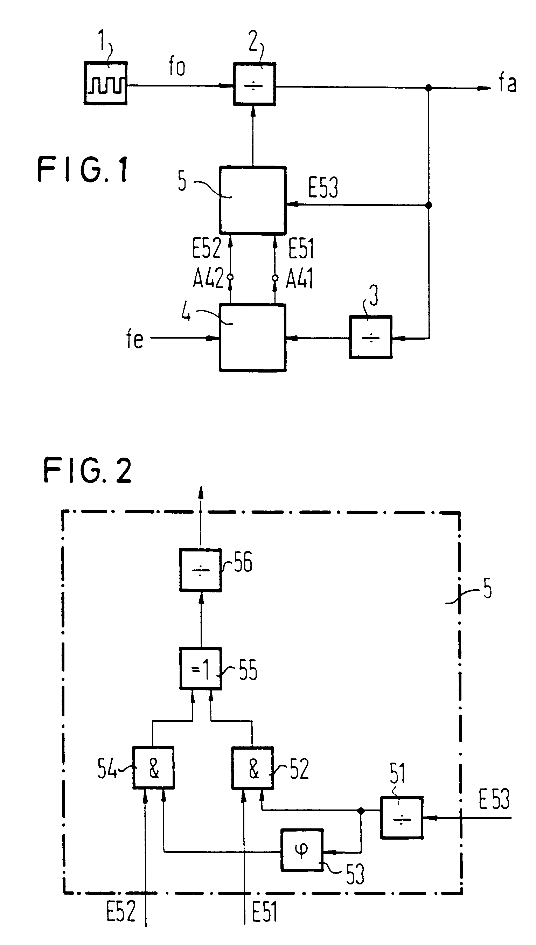

Der in Fig. 1 dargestellte Phasenregelkreis besteht aus einer Oszillatorschaltung 1, einem an die Oszillatorschaltung angeschlossenen Frequenzteiler 2, der zwischen zwei Teilungsfaktoren umschaltbar ist und der an seinem Ausgang ein Regelkreis-Ausgangssignal fa abgibt, aus einem Rückführungsteiler 3, der mit dem Regelkreis-Ausgangssignal fa beaufschlagt ist und dessen Ausgang mit einem ersten Eingang einer Phasendetektoreinrichtung 4 verbunden ist, deren zweiter Eingang mit einem Regelkreis-Eingangssignal fe beaufschlagt ist, sowie aus einer Logikschaltung 5, deren drei Eingänge E51, E52, E53 mit zwei Ausgängen A41, A42 der Phasendetektoreinrichtung 4 und mit dem Ausgang des Frequenzteilers 2 verbunden sind. Der Ausgang der Logikschaltung 5 ist mit einem Steuereingang des Frequenzteilers 2 verbunden.

Die Funktion des Phasenregelkreises ist wie folgt: Die Oszillatorschaltung 1 liefert ein Rechtecksignal fo mit annähernd konstanter Frequenz. Dieses Rechtecksignal wird durch den Frequenzteiler 2 mit umschaltbaren Teilungsfaktoren, wie beispielsweise 11 und 12, in das Regelkreis-Ausgangssignal fa umgesetzt. Die mittlere Frequenz des Regelkreis-Ausgangssignales fa ergibt sich als Quotient aus der Frequenz des Rechtecksignales fo und dem über das Verhältnis der Dauer ihres Auftretens gemittelten Wert der beiden Teilungsfaktoren. Beispielsweise ist die mittlere Frequenz des Regelkreis-Ausgangssignales fa bei gleich langem Auftreten der Teilungsfaktoren 11 und 12 gleich dem 11,5-ten Teil der Frequenz des Rechtecksignals fo. Der Frequenzbereich über den sich das Regelkreis-Ausgangssignal fa erstrecken kann, liegt zwischen fo/12 und fo/11, d.h. je geringer der Wert der Teilungsfaktoren und damit das Verhältnis zwischen der Frequenz des Rechtecksignals fo und der Frequenz des Regelkreis-Ausgangssignales fa ist, desto größer ist der mögliche Frequenzbereich für das Regelkreis-Ausgangssignal fa, desto größer wird allerdings auch der bei einem Umschaltvorgang des Frequenzteilers 2 im Regelkreis-Ausgangssignal fa auftretende Phasensprung. Bei der Auslegung des Phasenregelkreises ist auf diese Zusammenhänge Rücksicht zu nehmen.

Durch entsprechendes Umschalten des Frequenzteilers wird die Dauer des Auftretens der beiden Teilungsfaktoren und damit die Regelkreis-Ausgangsfrequenz fa bestimmt. Diese Umschaltung geschieht mittels der Logikschaltung 5, die beispielsweise nach Fig. 2 aufgebaut sein kann.

Das in dieser Figur dargestellte Ausführungsbeispiel umfaßt einen Teiler 51, dessen Ausgang mit einem Eingang eines ersten UND-Gatters 52 und einem Phasenelement 53 verbunden ist. Der Ausgang des Phasenelementes 53 ist an einen Eingang eines zweiten UND-Gatters 54 angeschlossen. Ein weiterer Eingang des ersten UND-Gatters 52 ist mit dem ersten Eingang E51 der Logikschaltung 5 und ein Eingang des zweiten UND-Gatters 54 mit dem zweiten Eingang E52 der Logikschaltung 5 verbunden. Die Aus- gänge der UND-Gatter 52, 54 sind mit Eingängen eines EXCLUSIV- ODER-Gatters 55 verbunden, dessen Ausgang mit einem Eingang eines Stellteilers 56 verbunden ist. Vom beispielsweise nach Art eines umlaufenden Zählers arbeitenden Stellteiler 56 erzeugte Steuersignalimpulse bewirken ein Umschalten des Frequenzteilers 2.

Die Funktionsweise der Logikschaltung ist folgendermaßen: Während des Auftretens eines "log 1"-Signales am ersten Eingang E51 der Logikschaltung 5 ist das UND-Gatter 52 für das Ausgangssignal des Teilers 51 durchlässig, d.h. dieses Ausgangssignal wird an den Ausgang des ersten UND-Gatters 52 als Taktsignal durchgeschaltet. Über das EXCLUSIV-ODER-Gatter 55 gelangen die Taktimpulse des Taktsignals an den Eingang des Stellteilers 56 der die Taktimpulse akkumuliert und bei jedem Überschreiten eines festgelegten Höchstwertes (Zählerstandes) durch die akkumulierten Taktimpulse einen Steuersignalimpuls liefert, dessen Auftreten ein Umschalten des Teilungsverhältnisses des Frequenzteilers 2 bewirkt, d.h. die Frequenz des Regelkreis-Ausgangssignales fa ändert sich bei dem oben angegebenen Beispiel von fo/12 auf fo/11 bzw. von fo/11 auf fo/12.

Während des Auftretens eines "log 1"-Signales am zweiten Eingang E52 der Logikschaltung 5 wird in gleicher Weise ein um 90° phasenverschobenes Ausgangssignal des Teilers 51 als Taktsignal durch das zweite UND-Gatter 54 als Taktsignal durchgeschaltet. Die Taktimpulse werden durch den Stellteiler 56 akkumuliert, der bei jedem Überschreiten des festgelegten Höchstwertes durch die akkumulierten Taktimpulse einen Steuersignalimpuls an seinem Ausgang abgibt.

Es kann vorkommen, daß am ersten Eingang E51 und am zweiten Eingang E52 der Logikschaltung 5 gleichzeitig ein "log 1"-Signal auftritt. In diesem Fall ist durch die 90°-Phasenverschiebung des Ausgangssignals des Teilers 51 mittels des Phasenelementes 53 gewährleistet, daß die Signale an den beiden Eingängen E51, E52 der Logikschaltung 5 in gleicher Weise zur Bildung von Steuersignalimpulsen am Ausgang des Stellteilers 56 beitragen.

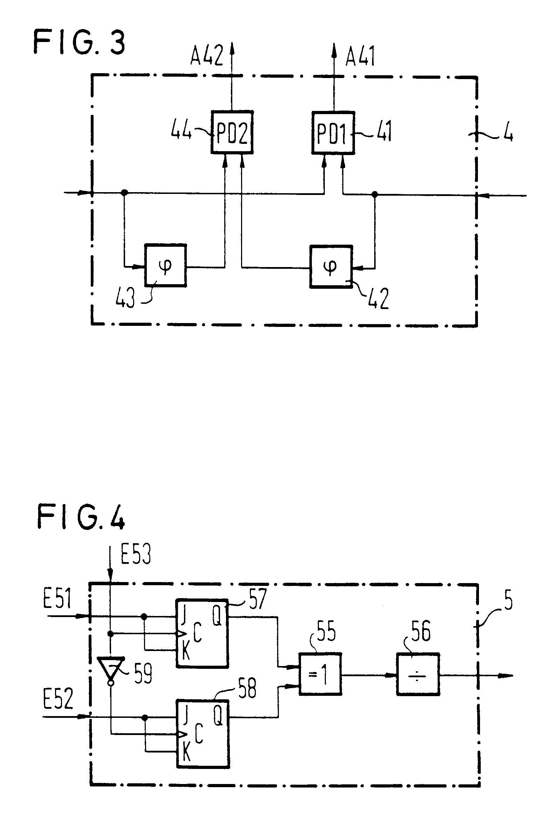

Fig. 3 zeigt ein Beispiel für eine Phasendetektoreinrichtung 4 mit einem ersten Phasendetektor 41, dem die beiden miteinander zu vergleichenden Eingangssignale (in dem Phasenregelkreis nach Fig. 1 das Regelkreis-Eingangssignal fe und das Signal am Ausgang des Rückführungsteilers 3) zugeführt werden und der mit einem Ausgang den ersten Ausgang A41 der Phasendetektoreinrichtung 4 bildet, und mit einem zweiten Phasendetektor 44, dem die betreffenden Eingangssignale über zwei Phasenschieber 42, 43 zugeführt werden und der mit einem Ausgang den zweiten Ausgang A42 der Phasendetektoreinrichtung 4 bildet.

Die beiden Phasendetektoren 41, 44 werden jeweils durch ein EXCLUSIV-ODER-Gatter gebildet. Ein derartiges Gatter liefert an seinem Ausgang ein Ausgangssignal "log 1" bei ungleichen Eingangssignalzuständen und ein Ausgangssignal "log 0" bei gleichen Eingangssignalzuständen. Bei einer Phasenverschiebung der Eingangssignale von 180° sind die Ausgangssignale durch- gehend "log 1", bei einer Phasenverschiebung der Eingangssignale von 0° sind die Ausgangssignale durchgehend "log 0". Die mit einem EXCLUSIV-ODER-Gatter maximal zu erfassende Phasenverschiebung beträgt daher ± 90°. Bei einer zwischen diesen beiden Werten liegenden Phasenverschiebung der Eingangssignale treten dagegen Ausgangssignalimpulse auf, die jeweils ein von der momentanen Phasenverschiebung abhängiges Tastverhältnis aufweisen. Der Betrag der Phasenverschiebung durch die beiden Phasenschieber 42, 43 beträgt jeweils 180°. Die Ausgangssignalimpulse des zweiten Phasendetektors 44 weisen daher dasselbe Tastverhältnis, aber eine andere Phasenlage als die Ausgangssignalimpulse des ersten Phasendetektors 41 auf.

Fig. 4 zeigt eine weitere beispielhafte Ausführungsform einer Logikschaltung 5. Sie umfaßt zwei JK-Flip Flops 57, 58, ein EXCLUSIV-ODER Gatter 55, einen Stellteiler 56 sowie einen Inverter 59. J-Eingang und K-Eingang des ersten JK-Flip Flops 57 sind mit dem ersten Eingang E51 der Logikschaltung 5 verbunden. J-Eingang und K-Eingang des zweiten JK-Flip Flops 58 sind mit dem zweiten Eingang E52 der Logikschaltung 5 verbunden. Der Takteingang C des ersten JK-Flip Flops 57 ist mit dem dritten Eingang E53 der Logikschaltung 5 verbunden. Die an diesem Eingang E53 auftretenden Signale werden außerdem über den Inverter 59 dem Takteingang C des zweiten JK-Flip Flops 58 zugeführt. Die Datenausgänge Q der beiden JK-Flip Flops 57, 58 sind mit den Eingängen des EXCLUSIV-ODER-Gatters 55 verbunden, dessen Ausgang an den Eingang des Stellteilers 56 angeschlossen ist. Der Ausgang des Stellteilers 56 bildet den Ausgang der Logikschaltung 5.

Die Funktion dieser Logikschaltung entspricht weitgehend der Funktion der Logikschaltung nach Figur 2. Abweichend von dieser erfolgt in der Logikschaltung nach Figur 4 die UND-Verknüpfung der Signale an den beiden Eingängen E51, E52 mit einem durch eine Frequenzteilung um den Faktor 2 aus dem Regelkreis-Ausgangssignal fa am dritten Eingang E53 abgeleiteten Signal mittels zweier JK-Flip Flops 57, 58. Die beiden JK-Flip Flops bewirken sowohl die angeführte UND-Verknüpfung als auch die Frequenzteilung des Regelkreis-Ausgangssignals fa. Ein weiterer Unterschied zur Logikschaltung nach Figur 2 ist durch den Einsatz eines Inverters 59 als Phasenschieber zu sehen, der eine Phasenverschiebung um 180° bewirkt. Diese Phasenverschiebung wird durch die anschließende Frequenzteilung um den Faktor 2 auf einen Wert von 90° geteilt und entspricht damit dem Wert in der Logikschaltung nach Fig. 2.

Bezüglich der vorstehend beschriebenen Ausführungsbeispiele sei noch darauf hingewiesen, daß diese mittels herkömmlicher log. Elemente unterschiedlicher Technologie (z.B. ECL, TTL, CMOS usw.) realisiert sein können, wodurch der Phasenregelkreis gemäß der vorliegenden Erfindung in beliebigen Frequenzbereichen einsetzbar ist, beispielsweise auch in der Höchstfrequenztechnik.

Der zuvor beschriebene erfindungsgemäße Phasenregelkreis kann jedoch auch derart modifiziert sein, daß die zuvor beschriebenen Funktionen der Phasendetektoreinrichtung 4 und der Logikschaltung 5 durch eine oder mehrere Mikroprozessorschaltungen realisiert werden.

Weiters kann die Phasendetektoreinrichtung 4 mehr als zwei Phasendetektoren aufweisen. In diesem Fall werden jedem weiteren Phasendetektor die zu vergleichenden Eingangssignale (in dem Phasenregelkreis nach Fig. 1 das Regelkreis-Eingangssignal fe und das Signal am Ausgang des Rückführungsteilers 3) über zwei weitere Phasenschieber zugeführt. Der Betrag der Phasenverschiebung durch die zwei weiteren Phasenschieber unterscheidet sich daher vom Betrag der Phasenverschiebung durch die vorangehenden Phasenschieber.

Der beschriebene Phasenregelkreis eignet sich besonders für den Einsatz in digitalen Informationsübertragungssystemen zur Synchronisierung eines in diesen jeweils bereitzustellenden internen Taktsignals (Regelkreis-Ausgangssignal fa) auf ein extern zugeführtes Taktsignals (Regelkreis-Eingangssignal fe), welches beispielsweise aus dem jeweiligen Informationsübertragungssystem zugeführten Datensignalen ableitbar ist oder gemeinsam mit den Datensignalen auftritt.

## Patentansprüche

1. Digitaler Phasenregelkreis bestehend aus:
- einer Oszillatorschaltung (1);
- einem zwischen zwei Teilungsfaktoren umschaltbaren Frequenzteiler (2), der einen Steuereingang, einen Signaleingang und einen Signalausgang aufweist und dessen Signaleingang mit einem Ausgang der Oszillator-schaltung (1) verbunden ist;
- einem an einem Ausgang ein Teilersignal abgebenden Rückführungsteiler (3), der mit einem Eingang an den Signalausgang des Frequenzteilers (2) angeschlossen ist;
- einer die Phasenbeziehung zwischen einem durch ein Regelkreis-Eingangssignal (fe) und dem Teilersignal gebildeten ersten Signalpaar durch das Tastverhältnis eines ersten Signals an einem ersten Ausgang (A41) darstellenden und die Phasenbeziehung n-1 weiterer Signalpaare, die gegenüber dem ersten Signalpaar jeweils um einen konstanten Betrag phasenverschoben sind, durch das Tastverhältnis von n-1 weiteren Signalen an n-1 weiteren Ausgängen (A42) darstellenden Phasendetektoreinrichtung (4), deren erster Eingang an den Ausgang des Rückführungsteilers (3) angeschlossen ist und deren zweiter Eingang mit dem Regelkreis-Eingangssignal (fe) beaufschlagt ist;
- einer ein Ausgangssignal mit einer mittleren Frequenz, die dem Tastverhältnis der n Signale an den n Ausgängen der Phasendetektoreinrichtung (4) proportional ist, abgebenden Logikschaltung (5) mit n+1 Eingängen (E51, E52, E53) und einem Ausgang, deren erster (E51) bis n-ter Eingang (E52) mit dem ersten (A41) bis n-ten Ausgang (A42) der Phasendetektoreinrichtung (4) verbunden sind, deren n+1 -ter Eingang (E53) mit dem Signalausgang des Frequenzteilers (2) und deren Ausgang mit dem Steuereingang des Frequenzteilers (2) verbunden ist.

2. Phasenregelkreis nach Anspruch 1,
**dadurch gekennzeichnet**,
daß n gleich zwei ist.

3. Phasenregelkreis nach Anspruch 2,
**dadurch gekennzeichnet**,
daß die Phasendetektoreinrichtung (4) folgende Einheiten umfaßt:
- einen ersten Phasendetektor (41) mit zwei Eingängen und einem Ausgang, dessen Eingänge mit den beiden Eingängen der Phasendetektoreinrichtung (4) verbunden sind und dessen Ausgang mit dem ersten Ausgang (A41) der Phasendetektoreinrichtung (4) verbunden ist;
- einen ersten Phasenschieber (42) mit einem Eingang und einem Ausgang, dessen Eingang mit dem ersten Eingang der Phasendetektoreinrichtung (4) verbunden ist;
- einen zweiten Phasenschieber (43) mit einem Eingang und einem Ausgang, dessen Eingang mit dem zweiten Eingang der Phasendetektoreinrichtung (4) verbunden ist;
- einen zweiten Phasendetektor (44) mit zwei Eingängen und einem Ausgang, dessen erster Eingang mit dem Ausgang des ersten Phasenschiebers (42) verbunden ist, dessen zweiter Eingang mit dem Ausgang des zweiten Phasenschiebers (43) verbunden ist und dessen Ausgang mit dem zweiten Ausgang (A42) der Phasendetektoreinrichtung (4) verbunden ist.

4. Phasenregelkreis nach Anspruch 2 oder 3,
**dadurch gekennzeichnet**,
daß die Logikschaltung (5) folgende Einheiten umfaßt:
- einen Teiler (51) mit einem Eingang, der mit dem dritten Eingang (E53) der Logikschaltung (5) verbunden ist, und mit einem Ausgang;
- ein erstes UND-Gatter (52) mit zwei Eingängen und einem Ausgang, dessen erster Eingang mit dem ersten Eingang (E51) der Logikschaltung (5) und dessen zweiter Eingang mit dem Ausgang des Teilers (51) verbunden ist;
- einen dritten Phasenschieber (53) mit einem Eingang und einem Ausgang, dessen Eingang mit dem Ausgang des Teilers (51) verbunden ist;
- ein zweites UND-Gatter (54) mit zwei Eingängen und einem Ausgang, dessen erster Eingang mit dem zweiten Eingang (E52) der Logikschaltung (5) und dessen zweiter Eingang mit dem Ausgang des dritten Phasenschiebers (53) verbunden ist;
- ein EXCLUSIV-ODER-Gatter (55) mit zwei Eingängen, die jeweils mit einem Ausgang der beiden UND-Gatter (52, 54) verbunden sind, und einem Ausgang;
- und einen Stellteiler (56) mit einem Eingang und einem Ausgang, dessen Eingang mit dem Ausgang des EXCLUSIV-ODER-Gatters (54) und dessen Ausgang mit dem Ausgang der Logikschaltung (5) verbunden ist.

5. Phasenregelkreis nach Anspruch 2 oder 3,
**dadurch gekennzeichnet**,
daß die Logikschaltung folgende Einheiten umfaßt:
- ein erstes JK-Flip Flop (57), dessen J-Eingang und K-Eingang gemeinsam mit dem ersten Eingang (E51) der Logikschaltung (5) verbunden sind und dessen Takteingang (C) mit dem dritten Eingang (E53) der Logikschaltung (5) verbunden ist,
- ein zweites JK-Flip Flop (58), dessen J-Eingang und K-Eingang gemeinsam mit dem zweiten Eingang der Logikschaltung (E52) verbunden sind und dessen Takteingang (C) über einen Inverter (59) mit dem dritten Eingang (E53) der Logikschaltung verbunden ist;
- ein EXCLUSIV-ODER-Gatter (55) mit zwei Eingängen und einem Ausgang, dessen Eingänge jeweils mit einem Datenausgang der beiden JK-Flip Flops (57, 58) verbunden sind;
- und einen Stellteiler (56) mit einem Eingang und einem Ausgang, dessen Eingang mit dem Ausgang des EXCLUSIV-ODER-Gatters (55) und dessen Ausgang mit dem Ausgang der Logikschaltung (5) verbunden ist.

6. Phasenregelkreis nach Anspruch 1 oder 2,
**dadurch gekennzeichnet**,
daß als Phasendetektoreinrichtung (4) und als Logikschaltung (5) wenigstens eine Mikroprozessorschaltung benutzt ist.

## Claims

1. Digital phase-locked loop comprising:
- an oscillator circuit (1);
- a frequency divider (2) which can be switched over between two division factors and has a control input, a signal input and a signal output and whose signal input is connected to an output of the oscillator circuit (1);
- a feedback divider (3) which outputs a divider signal at one output and is connected with one input to the signal output of the frequency divider (2);
- a phase detector device (4) which by means of the pulse duty factor of a first signal at a first output (A41) represents the phase relationship between a first signal pair, formed by a control loop input signal (fe) and the divider signal, and by means of the pulse duty factor of n-1 further signals represents at n-1 further outputs (A42) the phase relationship n-1 of further signal pairs, which are phase shifted with respect to the first signal pair by a constant amount in each case, the first input of which phase detector device is connected to the output of the feedback divider (3) and to the second input of which the control loop input signal (fe) is applied;
- a logic circuit (5) which outputs an output signal with a mean frequency proportional to the pulse duty factor of the n signals at the n outputs of the phase detector device (4) and has n+1 inputs (E51, E52, E53) and one output, the first (E51) to nth inputs (E52) of which logic circuit are connected to the first (A41) to nth outputs (A42) of the phase detector device (4), the (n+1)th input (E53) of which phase detector device is connected to the signal output of the frequency divider (2) and the output of which is connected to the control input of the frequency divider (2).

2. Phase-locked loop according to Claim 1, characterized in that n is equal to two.

3. Phase-locked loop according to Claim 2, characterized in that the phase detector device (4) comprises the following units:
- a first phase detector (41) having two inputs and one output, the inputs of which are connected to the two inputs of the phase detector device (4) and the output of which is connected to the first output (A41) of the phase detector device (4);
- a first phase shifter (42) having one input and one output, the output of which is connected to the first input of the phase detector device (4);
- a second phase shifter (43) having one input and one output, the input of which is connected to the second input of the phase detector device (4);
- a second phase detector (44) having two inputs and one output, the first input of which is connected to the output of the first phase shifter (42), the second input of which is connected to the output of the second phase shifter (43), and the output of which is connected to the second output (A42) of the phase detector device (4).

4. Phase-locked loop according to Claim 2 or 3, characterized in that the logic circuit (5) comprises the following units:
- a divider (51) having one input, which is connected to the third input (E53) of the logic circuit (5) and having one output;
- a first AND gate (52) having two inputs and one output, the first input of which is connected to the first input (E51) of the logic circuit (5) and the second input of which is connected to the output of the divider (51);
- a third phase shifter (53) having one input and one output, the input of which is connected to the output of the divider (51);
- a second AND gate (54) having two inputs and one output, the first input of which is connected to the second input (E52) of the logic circuit (1) and the second input of which is connected to the output of the third phase shifter (53);
- an EXCLUSIVE-OR gate (55) having two inputs which are respectively connected to one output of the two AND gates (52, 54), and one output;
- and a control divider (56) having one input and one output, the input of which is connected to the output of the EXCLUSIVE-OR gate (54) and the output of which is connected to the output of the logic circuit (5).

5. Phase-locked loop according to Claim 2 or 3, characterized in that the logic circuit comprises the following units:
- a first JK flip flop (57), whose J input and K input are jointly connected to the first input (E51) of the logic circuit (5) and whose clock input (C) is connected to the third input (E53) of the logic circuit (5),
- a second JK flip flop (58) whose J input and K input are jointly connected to the second input of the logic circuit (E52) and whose clock input (C) is connected via an inverter (59) to the third input (E53) of the logic circuit;
- an EXCLUSIVE-OR gate (55) having two inputs and one output, the inputs of which are respectively connected to a data output of the two JK flip flops (57, 58);
- and a control divider (56) having one input and one output, the input of which is connected to the output of the EXCLUSIVE-OR gate (55) and the output of which is connected to the output of the logic circuit (5).

6. Phase-locked loop according to Claim 1 or 2, characterized in that at least one microprocessor circuit is used as phase detector device (4) and as logic circuit (5).

## Revendications

1. Circuit numérique de régulation de phase constitué par :
- un circuit oscillant (1);
- un diviseur de fréquence (2) commutable entre deux facteurs de division et qui possède une entrée de commande, une entrée de signaux et une sortie de signaux, et dont l'entrée des signaux est reliée à une sortie du circuit oscillant (1);
- un diviseur de réaction (13), qui délivre un signal de division à une sortie et qui est raccordé, par une entrée, à la sortie des signaux du diviseur de fréquence (2);
- un dispositif de détection de phase (4), qui représente la relation de phase entre un premier couple de signaux, formé par un signal d'entrée (fe) du circuit de régulation et le signal de division, au moyen du taux d'impulsions d'un premier signal présent à une première sortie (A41) et qui représente la relation de phase de n-1 autres couples de signaux, qui sont déphasés respectivement d'une valeur constante par rapport au premier couple de signaux, au moyen du taux d'impulsions de n-1 autres signaux présents sur n-1 autres sorties (A42), et dont la première entrée est connectée à la sortie du diviseur de réaction (3) et dont la seconde entrée est chargée par le signal d'entrée (fe) du circuit de régulation;
- un circuit logique (5), qui délivre un signal de sortie possédant une fréquence moyenne, qui est proportionnelle au taux d'impulsions des n signaux délivrés sur les n sorties du dispositif de détection de phase (4) et comporte n+1 entrées (E51,E52,E53) et une sortie et dont les entrées allant de la première entrée (E51) jusqu'à la n-ème entrée (52) sont reliées aux sorties allant de la première sortie (A41) jusqu'à la n-ème sortie (A42) du dispositif de détection de phase (4) et dont la n+1-ème entrée (E53) est reliée à la sortie du signal du diviseur de fréquence (2) et dont la sortie est reliée à l'entrée de commande du diviseur de fréquence (2).

2. Circuit de régulation de phase suivant la revendication 1, caractérisé par le fait que n est égal à deux.

3. Circuit de régulation de phase suivant la revendication 2, caractérisé par le fait que le dispositif de détection de phase (4) comprend les unités suivantes :
- un premier détecteur de phase (41) comportant deux entrées et une sortie et dont les entrées sont reliées aux deux entrées du dispositif de détection de phase (4) et dont la sortie est reliée à la première sortie (A41) du dispositif de détection de phase (4);
- un premier déphaseur (42) comportant une entrée et une sortie et dont l'entrée est reliée à la première entrée du dispositif de détection de phase (4);
- un second déphaseur (43) comportant une entrée et une sortie et dont l'entrée est reliée à la seconde entrée du dispositif de détection de phase (4);
- un second détecteur de phase (44) comportant deux entrées et une sortie et dont la première entrée est reliée à la sortie du premier déphaseur (42), dont la seconde entrée est reliée à la sortie du second déphaseur (43) et dont la sortie est reliée à la seconde partie (A42) du dispositif de détection de phase (4).

4. Circuit de régulation de phase suivant la revendication 2 ou 3, caractérisé par le fait que le circuit logique (5) comprend les unités suivantes:
- un diviseur (51) comportant une entrée qui est reliée à la troisième entrée (E53) du circuit logique (5), et une sortie;
- une première porte ET (52) comportant deux entrées et une sortie et dont la première entrée est reliée à la première entrée (E51) du circuit logique (5) et dont la seconde entrée est reliée à la sortie du diviseur (51);
- un troisième déphaseur (53) comportant une entrée et une sortie et dont l'entrée est reliée à la sortie du diviseur (51);
- la seconde porte ET (54) comportant deux entrées et une sortie et dont la première entrée est reliée à la seconde entrée (E52) du circuit logique (5) et dont la seconde entrée est reliée à la sortie du troisième déphaseur (53);
- une porte OU-EXCLUSIF (55) comportant deux entrées qui sont reliées respectivement à une sortie des deux portes ET (52,54), et une sortie; et
- un diviseur de réglage (56) comportant une entrée et une sortie et dont l'entrée est reliée à la sortie de la porte OU-EXCLUSIF (54) et dont la sortie est reliée à la sortie du circuit logique (5).

5. Circuit de régulation de phase suivant la revendication 2 ou 3, caractérisé par le fait que le circuit logique comprend les unités suivantes :
- une première bascule bistable de type JK (57), dont l'entrée J et l'entrée K sont reliées en commun à la première entrée (51) du circuit logique (5) et dont l'entrée de cadence (C) est reliée à la troisième entrée (E53) du circuit logique (5),
- une seconde bascule bistable de type JK (58), dont l'entrée J et l'entrée K sont reliées en commun à la seconde entrée du circuit logique (E52) et dont l'entrée de cadence (C) est reliée, par l'intermédiaire d'un inverseur (59), à la troisième entrée (E53) du circuit logique;
- une porte OU-EXCLUSIF (55) comportant deux entrées et une sortie et dont les entrées sont reliées respectivement à une sortie de données des deux bascules bistables de type JK (57,58); et
- un diviseur de réglage (56) comportant une entrée et une sortie, dont l'entrée est reliée à la sortie de la porte OU-EXCLUSIF (55) et dont la sortie est reliée à la sortie du circuit logique (5).

6. Circuit de régulation de phase suivant la revendication 1 ou 2, caractérisé par le fait qu'on utilise comme circuit de détection de phase (4) et comme circuit logique (5) au moins un circuit à microprocesseur.
